Europäisches Patentamt

European Patent Office

Office européen des brevets

(11) Veröffentlichungsnummer: **0 322 734**

**A1**

## EUROPÄISCHE PATENTANMELDUNG

(21) Anmeldenummer: 88121386.2

(22) Anmeldetag: 21.12.88

(51) Int. Cl.⁴: **G01R 19/165**

(30) Priorität: 24.12.87 DE 3744079

(43) Veröffentlichungstag der Anmeldung:
**05.07.89 Patentblatt 89/27**

(84) Benannte Vertragsstaaten:
**CH DE FR GB IT LI SE**

(71) Anmelder: **Licentia Patent-Verwaltungs-GmbH**
**Theodor-Stern-Kai 1**
**D-6000 Frankfurt/Main 70(DE)**

(72) Erfinder: **Dorn, Willi**
**Weilstrasse 29**
**D-6277 Bad Camberg(DE)**
Erfinder: **Speh, Rainer, Dr.-Ing.**
**Wilhelm-Leuschner-Strasse 31**
**D-6100 Darmstadt(DE)**

(74) Vertreter: **Lertes, Kurt, Dr. et al**
**Licentia Patent-Verwaltungs-GmbH**
**Theodor-Stern-Kai 1**
**D-6000 Frankfurt/M 70(DE)**

(54) **Anordnung zum Umsetzen von einer innerhalb eines grossen Bereichs veränderlichen Spannung in ein binäres Informationssignal.**

(57) Gegenstand der Erfindung ist eine Anordnung zum Umsetzen von einer innerhalb eines großen Bereichs veränderlichen Spannung in ein binäres Informationssignal. Die Spannung wird einer Strombegrenzungsschaltung (4) zugeführt, die den Eingangsstrom der Anordnung, der zugleich Laststrom für die Spannungsquelle ist, mit steigender Spannung nur bis zu einem vorgebbaren Maximalwert ansteigen läßt. Bei weiter wachsender Spannung wird der Eingangsstrom auf einen in etwa konstanten oder wieder sinkenden Wert begrenzt. Der Strom der Strombegrenzungsschaltung (4) erzeugt in einem Detektor (5) ein binäres Ausgangssignal der einen oder anderen Wertigkeit, je nachdem, ob der Strom eine vorgegebene Schwelle über- oder unterschreitet.

FIG.2

## Anordnung zum Umsetzen von einer innerhalb eines grossen Bereichs veränderlichen Spannung in ein binäres Informationssignal

Die Erfindung bezieht sich auf eine Anordnung zum Umsetzen eines veränderlichen Eingangssignals in ein binäres Informationssignal mit einem Detektor, der bei bestimmten Werten des Eingangssignals sein binäres Ausgangssignal von einem in den anderen binären Zustand ändert

Es ist eine Anordnung zum Umsetzen einer veränderlichen Spannung in ein binäres Informationssignal bekannt, die einen Detektor für eine Spannung in Parallelschaltung mit der Reihenschaltung einer Konstantstromquelle und eines Optokopplers enthält. Zwischen diese Schaltung und die Quelle der Spannung ist ein Vorwiderstand gelegt, der den Eingangsstrom an die zulässige Stromaufnahme des Detektors für einen engen Spannungsbereich anpasst Elektronik 12/12.6.1987, S. 146, 147). Bei dieser bekannten Anordnung erzeugt die Konstantstromquelle den Vorwärtsstrom für die OptokopplerEmitterdiode, so dass im "Ein-Zustand" definierte Verhältnisse herrschen. Der LED-Strom ist entweder ein- oder ausgeschaltet, ein kontinuierlicher Übergang in Abhängigkeit von der Eingangsspannung entfällt

Charakteristisch für die bekannte Anordnung ist die Zener-Dioden-Brückenschaltung am Eingang, die sowohl Eingangsgleichspannungen als auch Eingangswechselspannungen begrenzt, um diese von den nachgeschalteten Schaltungselementen fernzuhalten.

Die Stromspannungskennlinie dieser Anordnung zeigt somit für Eingangsspannungen unterhalb der Zenerspannung rein ohmsches Verhalten. Dann setzt eine Spannungsbegrenzung ein. Deshalb müssen Spannungen, die grösser als die Begrenzungsspannung sind, durch Vorwiderstände vom Schaltungseingang ferngehalten werden. Für den Teil der Signalspannungen, der oberhalb der Zenerspannung liegt, wirkt die Gesamtanordnung aus dem Kopplerbaustein und dem notwendigen Vorwiderstand rein ohmsch. Das bedeutet, dass die Verlustleistung an der Gesamtschaltung in etwa quadratisch mit der Eingangsspannung ansteigt. Das bedeutet weiter, dass bei einem einmal gewählten Vorwiderstand und einem Eingangssignalpegelbereich von 1:10 z. B. 24 V... 240 V) die zu verkraftende Verlustleistung im Verhältnis 1:100 variiert. Wählt man dann aus Gründen der Störfestigkeit eine untere Verlustleistung von z. B 20 mW (bei 24 V), dann entsteht bei der grösseren Signalspannung (240 V) eine Verlustleistung von 2 W. Diese Verlustleistung ist in vielen Anwendungen insbesondere dann kritisch, wenn viele Eingangsschaltungen auf einer Leiterplatte angebracht sind.

Um die Verlustleistung gering zu halten, muss der jeweilige Eingangsstrom für die Signalspannungen durch individuelle Vorwiderstandswerte auf einen dem jeweiligen Detektor angepassten Wert begrenzt werden.

Elektronische Geräte werden häufig für die Überwachung von Temperatur- und Druckwerten, die Stellung von Bedienungselementen usw. eingesetzt. Die zu überwachenden Elemente befinden sich vielfach in grösseren Entfernungen vom elektronischen Gerät. Die Überwachungssignale müssen häufig bei längeren Leitungen wegen der grossen Dämpfung und hoher Störpegel hohe Pegel aufweisen Damit die Signale am elektronischen Gerät sicher festgestellt werden können, werden die zu überwachenden Elemente und die Leitungen je nach der Entfernung zum Ort der Umwandlung in binäre Signale mit Spannungen beaufschlagt, die hoch oder niedrig sein können. Dies trifft insbesondere dann zu, wenn Geber und Geräte untterschiedlicher Technik und Normen und von verschiedenen Herstellern miteinander kommunizieren müssen. Die an den Leitungsenden anstehenden Signale werden in binäre Signale für das jeweilige Gerät umgewandelt.

Der Erfindung liegt die Aufgabe zugrunde, eine Anordnung der Eingangs beschriebenen Gattung derart weiterzuentwickeln, dass innerhalb eines grossen Bereichs veränderliche Eingangssignale ohne Veränderung oder Austausch von Schaltungskomponenten in ein binäres Informationssignal umgesetzt werden können, wobei die in der Anordnung umgesetzte Verlustleistung dem angelegten Eingangssignal nicht mehr als ungefähr proportional ist. Unter Eingangssignal ist hierbei ein Strom oder eine Spannung zu verstehen.

Die Aufgabe wird erfindungsgemäss durch die im Anspruch 1 angegebenen Massnahmen gelöst. Aus Gründen der Störsicherheit muss bei einem Detektor an der unteren Grenze des Eingangssignalbereichs eine Mindestlast (z. B. 1 mA) aufgenommen werden. Je nach dem Einsatzort, z B. im industriellen Bereich mit hohen Störeinflüssen, muss die Mindestlast auch vergrössert werden. Wenn ein Detektor an der unteren Grenze des Spannungsbereichs (z B. 15 V bis 25 V) die Mindestverlustleistung aufnimmt, dann ergibt sich im oberen Spannungsbereich eine grössere Verlustleistung.

Mit der im Anspruch 1 beschriebenen Anordnung steigt die von den Strömen erzeugte Verlustleistung nicht quadratisch mit der angelegten Spannung an. Dies ist für die Bemessung der Bauelemente der Strombegrenzungsschaltung und des Stromdetektors von Bedeutung. Da sich die Verlustleistung mit der Spannung im Rahmen eines vorgegebenen Eingangsspannungsbereichs ändert, müssen die Bauelemente nur für die im wesentlichen proportionale Verlustleistungsänderung ausgelegt sein. Hierdurch ergeben sich Einsparungen in bezug auf Abmessungen und thermischer Beanspruchung der Bauelemente. Der Detektor kann insbesondere den Strom der Strombegrenzungsschaltung auf eine vorgegebene Schwelle hin überwachen.

Bei einer bevorzugten Ausführungsform enthält die Strombegrenzungsschaltung Elemente, die jeweils den Strom auf einen höheren und einen niedrigeren Wert begrenzen, wobei die Elemente, die den Strom auf einen niedrigeren Wert begrenzen, innerhalb einer vorgebbaren Zeit nach der Einschaltung der Spannung für die Strombegrenzung unwirksam sind. Mit dieser Anordnung wird eine Strombegrenzung und in Verbindung damit ein eigener Verlustleistungsbereich in zwei Stufen erreicht. Die höhere Stufe wird nur kurze Zeit ereicht, in der die Quelle der Spannung einen höheren Strom liefern soll, der z B. zur Kontaktreinigung von Schaltern benötigt wird.

Vorzugsweise enthält die Strombegrenzungsschaltung ein Verstärkerelement, das in Reihe mit mindestens einem Widerstand an von der Spannung beaufschlagte Leitungen angeschlossen ist und dessen Steuereingang an die gemeinsame Verbindungsstelle der an die Leitungen angeschlossenen Reihenschaltung eines Widerstands und eines Spannungsbegrenzungselements gelegt ist. Durch die Ansteuerung des Verstärkerelements mit gleichbleibender Spannung wird gewährleistet, daß das Verstärkerelement einen im wesentlichen konstanten Strom unabhängig vom Pegel auf den Leitungen in den Widerstand einspeist. Die Anordnung benötigt keine gesonderte Betriebsspannungsquelle, sondern wird vom Pegel auf den Leitungen gespeist. Die Anordnung zeichnet sich durch einen besonders einfachen Aufbau aus. Das Verstärkerelement kann für eine hohe Betriebsspannung ausgelegt sein. Es ist möglich, Pegel, deren Werte sich innerhalb einer Dekade ändern, zu verarbeiten.

Die oben beschriebene Anordnung hat einen von der Spannung im wesentlichen unabhängigen Eingangsstrom. Um die Strombegrenzungsschaltung in Betrieb zu setzen, muß die Spannung eine Schwelle überschreiten, die beispielsweise für die Erzeugung einer binären "0" oder "1" am Ausgang maßgebend ist. Ist die Spannung kleiner als die Schwelle, dann führt der Ausgang eine binäre "0", anderenfalls eine binäre "1".

Als Verstärkerelemente können bipolare Transistoren oder Feldeffekttransistoren verwendet werden. Feldeffekttransistoren sind besonders günstig, weil nur geringe Steuerströme oder nur Steuerpotentiale benötigt werden. Als Spannungsbegrenzungselement wird vorzugsweise eine Zener-Diode eingesetzt. Die Steuerstromkreise sind in diesem Fall sehr einfach aufgebaut. Vorzugsweise beaufschlagt die Spannung einen Gleichrichter, an den die Strombegrenzungsschaltung angeschlossen ist. ordnung eignet sich für die Umwandlung von Gleich- oder Wechselspannungen in binäre Informationssignale, die von elektronischen Geräten z. B. Mikrocomputern weiterverarbeit werden können.

Der Gleichrichter kann vorzugsweise ein Brückengleichrichter sein, damit keine Unterbrechung des Spannungsverlaufs an der Stromquelle bei negativen bzw. positiven Halbwellen auf den Leitungen eintritt. Außerdem hat der Gleichrichter den Vorteil, daß unabhängig vom Vorzeichen des Potentials auf den Leitungen der Stromquelle immer das richtige Potential zugeführt wird. Es muß also beim Anschließen der Anordnung an die von der Spannung gespeisten Leitungen nicht auf eine bestimmte Reihenfolge geachtet werden.

Vorzugsweise ist in Reihe mit dem Widerstand die Lumineszenzdiode eines Optokopplers gelegt. Mit dieser Anordnung lassen sich die binären Informationssignale potentialgetrennt von den Pegeln auf den Leitungen erzeugen.

Die Strombegrenzungsschaltung kann auch eine Konstantstromdiode sein. Für manche Anwendungsfälle ist es günstig, wenn die Strombegrenzungsschaltung einen Bereich mit negativem Widerstand aufweist.

In dem die Strombegrenzungsschaltung enthaltenden Stromkreis kann in Reihe mit der Strombegrenzungsschaltung ein spannungsbegrenzendes Element angeordnet sein, um die Schaltschwelle für den Wert der Eingangsspannung zu erhöhen.

Die Erfindung wird im folgenden anhand von in einer Zeichnung dargestellten Ausführungsbeispielen näher beschrieben, aus denen sich weitere Einzelheiten, Merkmale und Vorteile ergeben.

Es zeigen:

Fig. 1 ein Blockschaltbild einer Anordnung zum Umsetzen einer innerhalb eines großen Bereichs veränderlichen Spannung in ein binäres Informationssignal,

Fig. 2 ein Schaltbild der Anordnung zum Umsetzen einer innerhalb eines großen Bereichs veränderlichen Spannung in ein binäres Informationssignal,

Fig. 3 ein detailliertes Schaltbild einer Anordnung zum Umsetzen einer innerhalb eines großen Bereichs veränderlichen Spannung in ein binäres Informationssignal,

Fig. 4 ein detailliertes Schaltbild einer weiteren Anordnung zum Umsetzen von auf zwei Leitungen anstehenden Signalpegeln in galvanisch entkoppelte, binäre Informationssignale,

Fig. 5 ein detailliertes Schaltbild einer weiteren Anordnung zum Umsetzen von auf zwei Leitungen anstehenden Signalpegeln in galvanisch entkoppelte, binäre Informationssignale,

Fig. 6 ein Diagramm des von einer der in Fig. 1 bis 5 dargestellten Anordnungen aufgenommenen Stroms in Abhängigkeit von der angelegten Eingangsspannung,

Fig. 7 ein Schaltbild einer Anordnung mit fallender Kennlinie des Stroms.

Eine Anordnung 1 zum Umsetzen einer innerhalb eines großen Bereichs veränderlichen Spannung in ein binäres Signal enthält Eingänge 2, 3, an die die jeweilige Spannung angelegt wird. Die Anordnung 1 soll universell für einen vorgegebenen Bereich eingesetzt werden. Eine Anpassung der Anordnung an die jeweils in einer Anlage vorhandene Spannung ist daher nicht mehr nötig. Die Anordnung 1 kann z. B. in einem Fall an eine Spannungsquelle angeschlossen werden, die eine dem Ende des Bereichs entsprechende Spannung abgibt. In einem anderen Fall wird die Anordnung 1 an eine Spannungsquelle angeschlossen, die eine Spannung innerhalb des Bereichs oder am unteren Ende des Bereichs erzeugt. Indem gleiche Anordnungen für verschieden hohe Spannungen verwendet werden können, erübrigt sich eine auf jeweils einzelne Spannungen abgestimmte Umsetzeranordnung. Von den Eingängen 2, 3 verlaufen nicht näher bezeichnete Leitungen zu einer Strombegrenzungsschaltung 4 und einem mit diesem verbundenen Detektor 5 für Strom. Der Detektor 5 gibt an einem Ausgang 6 ein binäres Signal aus, wenn das

Eingangssignal eine bestimmte Schwelle überschreitet. Von der Strombegrenzungsschaltung 4 wird der über die Eingänge 2, 3 fließende Strom zumindest auf einen in etwa gleichbleibenden Wert begrenzt. Es ist auch möglich, eine Strombegrenzungsschaltung mit einer z. B. in einem Teilbereich negativen Widerstandskennlinie zu verwenden, so daß der Strom bei steigender Spannung abnimmt.

In der Anordnung 1 wird bei Beaufschlagung durch die Spannung infolge des Stromflusses eine Verlustleistung erzeugt. Durch die Strombegrenzung steigt diese Verlustleistung nicht bei zunehmender Spannung überproportional zur Spannung an. Damit ergeben sich im Rahmen eines großen Spannungsänderungsbereichs Verlustleistungen, die den Spannungen etwa proportional sind. Relativ kostengünstige Bauelemente, die diesen Verlustleistungen standhalten, können für die Anordnung 1 ausgewählt werden.

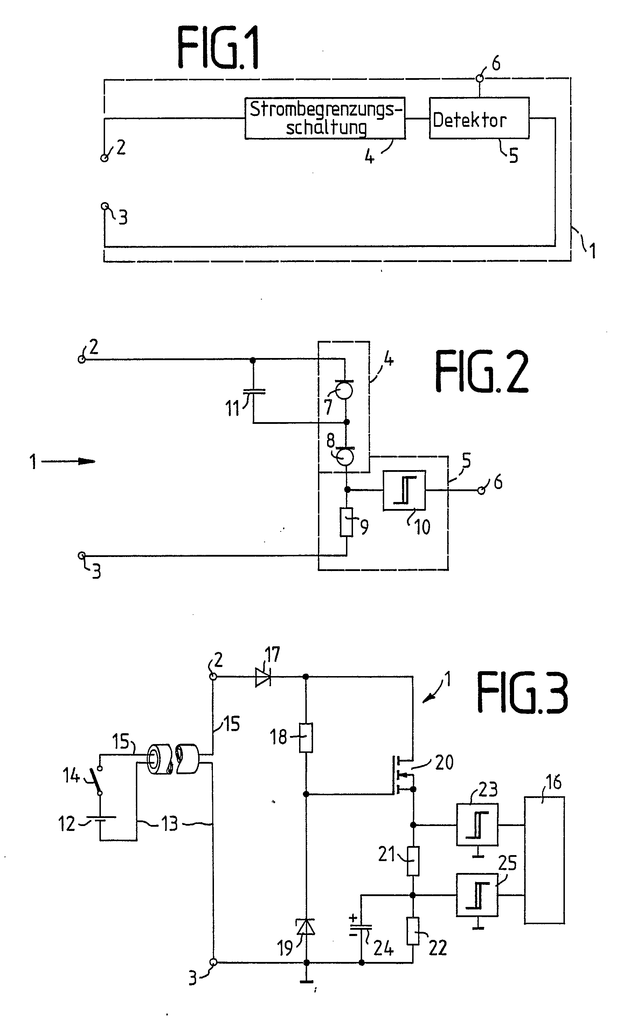

Bei der in Fig. 2 dargestellten Anordnung ist die Strombegrenzungsschaltung 4 derart ausgebildet, daß sie den Strom auf zwei unterschiedliche Werte begrenzen kann. Zur Strombegrenzung auf zwei verschiedene Werte sind z. B. zwei in Reihe geschaltete Strombegrenzungsdioden 7, 8 vorgesehen. Strombegrenzungsdioden sind z. B. unter der Typenbezeichnung 1N5283 bis 1N5314 der Fa. MOTOROLA kommerziell erhältlich. Die Strombegrenzungsdioden 7, 8 sind in Reihe mit einem Widerstand 9 angeordnet, der sich innerhalb des Detektors 5 befindet. Mit dem Widerstand 9 ist ein Schwellwertdetektor 10, z. B. ein Schmitt-Trigger, verbunden, der den Ausgang 6 speist. Die Strombegrenzungsdiode 7 ist durch einen Kondensator 11 überbrückt.

Beim Einschalten der an die Eingänge 2, 3 gelegten Spannung wirkt der Kondensator 11 zunächst als Kurzschluß, so daß nur die Strombegrenzungsdiode 8 den Strom auf einen höheren Wert begrenzt. Dieser höhere Wert ist vielfach erwünscht, um Schaltkontakte zu reinigen bzw. den Kontaktübergangswiderstand zu reduzieren. Nach dem Aufladen des Kondensators fließt der Strom auch über die Strombegrenzungsdiode 7, die den Strom auf einen niedrigeren Wert begrenzt.

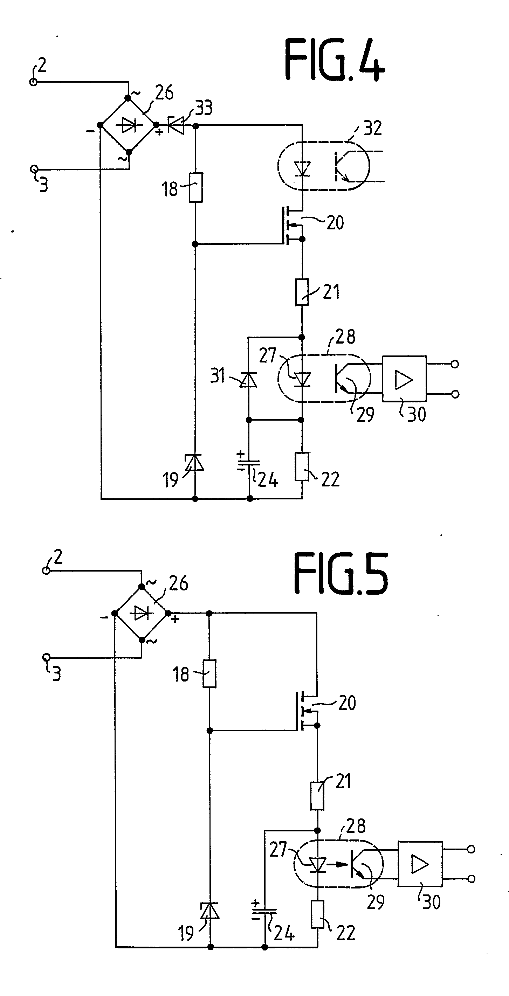

Die Fig. 3 zeigt eine Anordnung 1, die an ein Schaltelement 14 angeschlossen ist, bei dem es sich um einen Arbeitskontakt handelt, der an den einen Pol einer Gleichspannungsquelle 12 angeschlossen, deren anderer Pol mit einer Leitung 13 eines nicht näher bezeichneten Kabels verbunden ist. Die Gleichspannungsquelle 12 gibt beispielsweise 220 V ab. Mit dem Schaltelement 14 ist ferner eine Leitung 15 des zweiadrigen Kabels verbunden. Das Schaltelement 14 ist in größerem Abstand von einem Auswertgerät 16 angeordnet, das binäre Signale verarbeitet, denen die Stellung des Schaltelements 14 zugeordnet ist. Der offenen Stellung des Schaltelements 14 entspricht der binäre Wert "0", während der geschlossenen Stellung der binäre Wert "1" zugeordnet ist.

An einem Ende des Kabels steht die Leitung 15 über den Eingang 2 mit einem Gleichrichter 17 in Verbindung. Zwischen der Kathode des Gleichrichters 17 und der Leitung 13 ist die Reihenschaltung eines Widerstands 18 und eines spannungsbegrenzenden Elements, insbesondere einer Zener-Diode 19, angeordnet. Parallel zu der Reihenschaltung des Widerstands 18 und der Zener-Diode 19 ist als Verstärkerelement ein MOS-Feldeffekttransistor 20 mit seiner Drain-Source-Strecke in Reihe mit einem ersten und einem zweiten Widerstand 21, 22 gelegt. Es kann auch ein bipolarer Transistor verwendet werden, dessen Basis an die Zener-Diode 19 angeschlossen ist und dessen Emitter-Kollektor-Strecke in Reihe mit den Widerständen 21, 22 angeordnet ist. Die Gate-Elektrode des Feldeffekttransistors 20 ist an die gemeinsame Verbindungsstelle des Widerstands 18 und der Zener-Diode 19 angeschlossen.

Mit der Source-Elektrode des Feldeffekttransistors 20 ist ein erster Schwellwertdiskriminator 23 verbunden, der ausgangsseitig an das Auswertgerät 16 angeschlossen ist.

Parallel zum Widerstand 22 ist ein Kondensator 24 angeordnet. An die gemeinsame Verbindungsstelle zwischen den beiden Widerständen 21, 22 ist ein weiterer Schwellwertdiskriminator 25 angeschlossen, der ebenfalls ausgangsseitig an das Auswertgerät 16 angeschlossen ist. Im allgemeinen genügt für einen bestimmten Anwendungsfall einer der beiden Schwellwertdiskriminatoren 23 bzw. 25.

Der MOS-Feldeffekttransistor 20 bildet mit den Widerständen 21 und 22 einen Sourcefolger, der mit dem Widerstand 18 und der Zener-Diode 19 zu einer Stromquelle vereinigt ist, die einen konstanten Strom in die Widerstände 21, 22 einspeist. Der Widerstand 18 ist so hochohmig gewählt, daß der Strom über den Widerstand 18 und die Zener-Diode 19 gegenüber dem über den Feldeffekttransistor 20 fließenden Strom vernachlässigbar klein ist. Wenn das Potential auf den Leitungen 13, 15 kleiner als die Steuerschwellspannung des Feldeffekttransistors 20 ist, sperrt dieser. Es fließt ein Eingangsstrom, wenn die Spannung am Eingang größer als die Summe der Steuerschwellspannung und der Flußspannung des Gleichrichters 17 sowie gegebenenfalls der Zener-Spannung einer Zener-Diode ist, die bedarfsweise in Reihe mit dem Gleichrichter 17 geschaltet ist. Über den Feldeffekttransistor 20 fließt hierbei ein Strom. Bei weiter ansteigender Eingangsspannung folgt die Spannung an der Source-Elektrode der um die Schwellenspannung des Feldeffekttransistors 20 und die Flußspannung des Gleichrichters 17 bzw. der Zener-Spannung einer gegebenenfalls vorhandenen Zener-Diode verminderten Eingangsspannung, bis eine Schwellenspannung erreicht ist, die der Summe der Zener-Dioden-Spannung der Zener-Diode des Basis- bzw. Gate-Kreises der Flußspannung des Gleichrichters und - falls vorhanden -der Zener-Dioden-Spannung entspricht. Wenn der Feldeffekttransistor 20 gesperrt ist, führen die Ausgänge der Schwellwertdiskriminatoren 23, 25 binäre "0"-Signale. Wenn über den Feldeffekttransistor 20 ein Strom fließt, der an den Widerständen 21, 22 einen Spannungsabfall vorgegebener Größe erzeugt, gibt der Schwellwertdiskriminator 20 ein binäres "1"-Signal aus. Der Spannungsabfall am Widerstand 22 bei einem vorgegebenen Wert des Stroms veranlaßt den Schwellwertdiskriminator 25 zur Erzeugung eines binären "1"-Signals.

Die beiden Widerstände 21, 22 bilden zusammen mit dem Kondensator 24 die bestimmenden Elemente für die beiden Stromwerte. Sie werden zugleich dazu ausgenutzt, die Spannungen für die Schwellwertdiskriminatoren 23, 25 zu erzeugen. Der Vorteil dieser Maßnahme ist in einer Schaltungsvereinfachung zu sehen.

Der Kondensator 24 bewirkt beim Einschalten der Spannung durch Kurzschließen des Widerstands 22 einen Einschaltstrom, der höher als der sonst fließende Strom ist. Der höhere Einschaltstrom kann zur Kontaktreinigung verwendet werden.

Wenn ein sofortiges Ansprechen eines Schwellwertdiskriminators bei einer entsprechend hohen Eingangsspannung gewünscht wird, dann wird der Schwellwertdiskriminator 23 verwendet.

Insbesondere bei Störimpulsen auf den Leitungen 13 und 15 ist eine verzögerte Erzeugung der binären Informationssignale von Vorteil. In diesem Fall ist der Schwellwertdiskriminator 25 vorteilhaft.

Wenn der Feldeffekttransistor 20 bzw. bipolare Transistor leitend wird, lädt der Strom zunächst den Kondensator 24 auf. Übersteigt die Spannung am Widerstand 22 die Schwelle des Schwellwertdiskriminators 25, dann erzeugt der Schwellwertdiskriminator 25 an seinem Ausgang einen hohen Pegel, der z. B. der binären "1" zugeordnet ist. Durch das verzögerte Ansprechen des Schwellwertdiskriminators 25 wird verhindert, daß kurzzeitige Störspannungen zu falschen binären Informationssignalen führen. Wird kein erhöhter Einschaltstrom verlangt, dann kann der Kondensator 24 mit einem Widerstand (z. B. 21) entfallen.

Die in Fig. 3 dargestellte Anordnung arbeitet in einem weiten Spannungsbereich, dessen obere Grenze nur durch die zulässige Drain-Source-Spannung des Feldeffekttransistors 20 begrenzt ist. Die Verlustleistung in der Anordnung 1 verhält sich im wesentlichen proportional zur angelegten Spannung. Die Diode 17 verhindert, daß bei falscher Polung die in Fig. 3 dargestellte Anordnung zerstört wird.

Die Fig. 4 zeigt eine Anordnung, bei der ein Brückengleichrichter 26 an die Eingänge 2, 3 angeschlossen ist. An den Brückengleichrichter sind der Widerstand 18 und die Zener-Diode 19 in gleicher Weise wie bei der Anordnung gemäß Fig. 3 in Reihe angeschlossen. Der Feldeffekttransistor 20 dessen Gate-Elektrode mit der Zener-Diode 19 und dem Widerstand 18 verbunden ist, ist in Reihe mit den Widerständen 21 und 22 sowie einer Lumineszenzdiode 27 eines Optokopplers 28 an die Ausgänge des Brückengleichrichters 26 angeschlossen. Parallel zu der Reihenschaltung des Widerstands 22 und der Lumineszenzdiode 27 ist der Kondensator 24 gelegt. Dem Phototransistor 29 des Optokopplers 28 ist ein Verstärker 30 nachgeschaltet, der als Signalformer, z. B. Schmitt-Trigger, ausgebildet sein kann.

Der Brückengleichrichter 26 verhindert eine Falschpolung der Anordnung. Zugleich ermöglicht der Brückengleichrichter 26 den Betrieb der Anordnung mit Wechselspannung. Die aus dem Widerstand 18 der Zener-Diode 19, dem MOS-Feldeffekttransistor 20 und den Widerständen 21, 22 bestehende Anordnung arbeitet ebenso wie die entsprechende Anordnung gemäß Fig.3 als Strombegrenzungsschaltung. Der Kondensator 24 bewirkt ein verzögertes Ansprechen der Lumineszenzdiode 27, die nach der Aufladung des Kondensators 24 vom Konstantstrom durchflossen wird und den Phototransistor 29 ansteuert, der über den Verstärker 30 ein Signal mit hohem Pegel, der z.B. einer binären "1" zugeordnet ist, erzeugt. Die binären Imformationssignale werden mit der Anordnung gemäß Fig.4 galvanisch getrennt von der Spannung auf den Leitungen 3, 5 erzeugt.

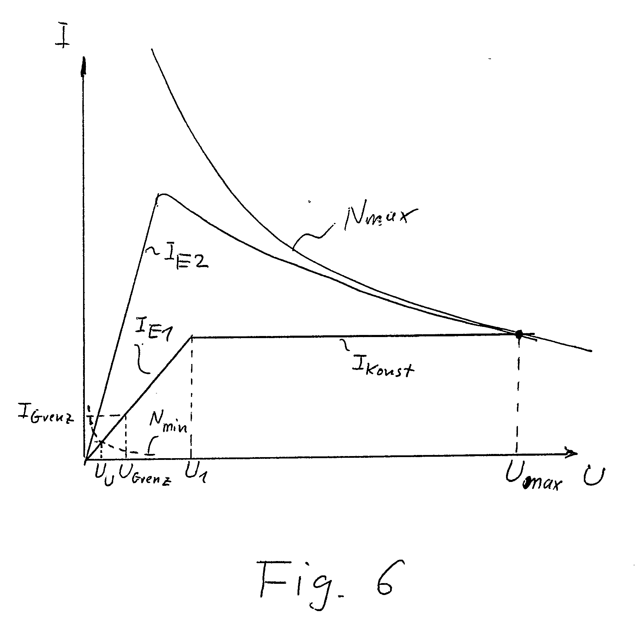

Die in Fig.5 dargestellte Anordnung unterscheidet sich nur in dem Schaltungsteil, der sich an den Widerstand 21 anschließt, von der Anordnung gemäß Fig.4. Der Optokoppler 28 ist parallel zu einer bezüglich der Polarität der Spannung der Source-Elektrode in Sperrichtung gepolten Diode 31 geschaltet. Die Diode 31 verhindert, daß bei Wegfall der Eingangsspannung die Lumineszenzdiode 27 von der Ladespannung des Kondensators 24 beaufschlagt wird. Außerdem ist der Kondensator 24 parallel zum Widerstand 22 angeordnet. Mit der Anordnung gemäß Fig.5 wird bei einer entsprechenden Spannung das binäre Informationssignal galvanisch getrennt und unverzögert erzeugt. Anstelle des Feldeffekttransistors 20 kann auch ein bipolarer Transistor verwendet werden.

Wegen des Kondensators 24 ist der Einschaltstrom der in den Fig.3 bis 5 dargestellten Anordnungen höher als der Dauer-Eingangsstrom. Durch die Bemessung der Widerstände 21, 22 und des Kondensators 24 kann ein bestimmter Einschaltstrom erzeugt werden, der z.B. bei mechanischen Kontaktgebern für die Kontaktreinigung und zur Erhöhung der Einschaltenergie bei kleiner Halteenergie benutzt wird. Die Anordnungen gemäß Fig.1 bis 5 haben folgende Vorteile hinsichtlich des Eingangsverhaltens:

a) weiter Eingangsspannungsbereich für "Ein-Signal" (z. B. 20...250 V),

b) konstanter Dauer-Eingangsstrom für "Ein-Signal", unabhängig vom Eingangsspannungsbereich dimensionierbar,

c) wahlweise erhöhter Einschaltstrom (wünschenswert zur Kontaktreinigung bei mechanischen Signalgebern und zur Erhöhung der Einschaltenergie (Entstörung) dabei kleine Halteenergie (Dauer-Verlustleistung)), unabhängig vom Eingangsspannungsbereich und Haltestrom dimensionierbar,

d) unipolare Eingänge, d. h. auch für Wechselspannungen geeignet,

e) Potentialtrennung, falls erwünscht,

f) keine eigene Spannungsversorgung der Schaltung notwendig.

Bezüglich des Ausgangs sind folgende Vorteile vorhanden:

a) Aufbau wahlweise mit oder ohne (RC-) Schaltverzögerung,

b) Auskopplung direkt potentialgebunden oder über Optokoppler potentialfrei.

Ein Optokoppler 32 kann auch im Drainkreis des Feldeffekttransistors 20 angeordnet sein. Der Optokoppler 32 ist in Fig.4 gestrichelt dargestellt. Für manche Anwendungsfälle ist ein mit der Wechselspannung der Spannungsquelle periodisches Signal zweckmäßig, das mittels des Optokopplers 32 erzeugt werden kann.

Dem Gleichrichter 26 ist vorzugsweise ein spannungsbegrenzendes Element, insbesondere eine Zener-Diode 33, nachgeschaltet, um die Schaltschwelle für den Wert der Eingangsspannung zu erhöhen.

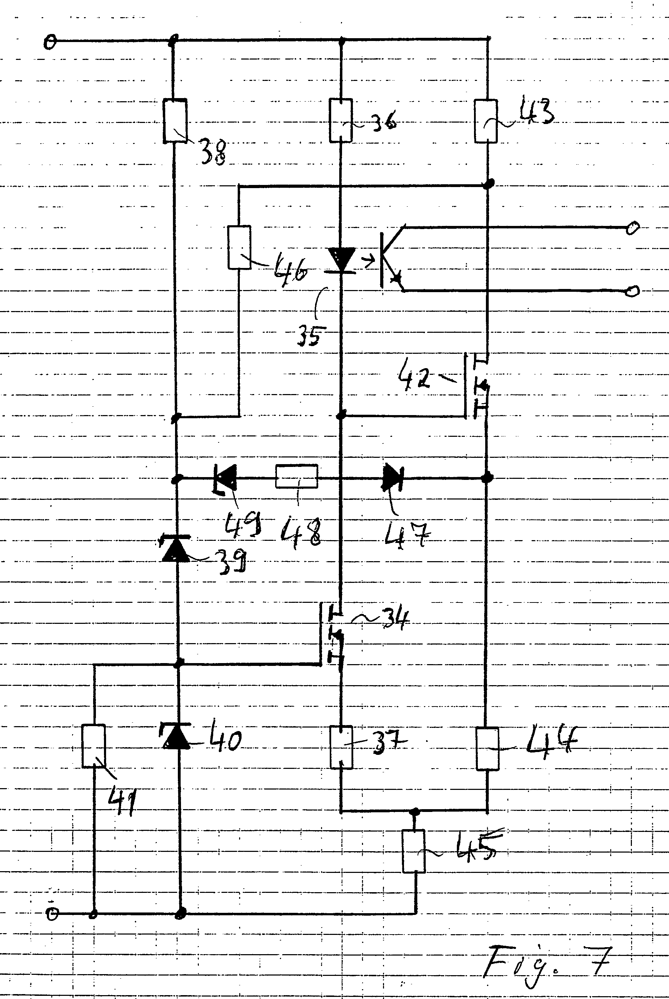

Die Fig 6 zeigt für Anordnungen gemäss der Erfindung Ströme in Abhängigkeit von angelegten Spannungen, die in Abszissenrichtung eines kartesischen Koordinatensystems dargestellt sind. Die Ströme sind mit I und die Spannungen mit U bezeichnet. Im Bereich zwischen der Spannung 0 und einer Spannung $U_1$ die vom Aufbau der Schaltungsanordnung und der Bemessung der Schaltungskomponenten abhängt, steigt der aufgenommene Strom $I_{E1}$ linear an. Ab der Spannung $U_1$ wird der Strom auf einen in etwa konstanten Wert $I_{kon}$" begrenzt. Die Anordnung kann so bemessen sein, dass das binäre Ausgangssignal bei einer Spannung $U_{Grenz}$ bzw. einem Strom $I_{Grenz}$ seine Wertigkeit ändert. Aus Gründen der Unempfindlichkeit gegen Störspannungen wird eine gewisse Mindestleistung bei einer unteren Grenze $U_U$ der Eingangsspannung verlangt. Hieraus ergibt sich der Eingangswiderstand bei der Grenze $U_U$, der die Steigung des Stroms $I_{E1}$ bestimmt. Ab der Spannung $U_1$ bleibt der Strom konstant, so dass die Verlustleistung proportional der Spannung U zunimmt. Die Anordnung ist so ausgelegt, dass bei einer bestimmten Umgebungstemperatur und einer oberen Grenze der Eingangsspannung $U_{max}$ die entstehende Verlustleistung $N_{max}$ ohne Erhöhung der zulässigen Bauelementetemperatur abgeführt wird. Würde der Strom so begrenzt werden, dass sich immer die gleiche Verlustleistung ergibt, dann würde sich, wenn die Verlustleistung $N_{max}$ als Wert angenommen wird, die in Fig. 6 mit $N_{max}$ bezeichnete Verlustleistungshyperbel ergeben. Für die minimale Verlustleistung $N_{min}$, d. h die für eine bestimmte Störeinflussunterdrückung notwendige Verlustleistung, ist in Fig. 6 die mit $N_{min}$ bezeichnete Verlustleistungshyperbel dargestellt.

Eine fallende Kennlinie des Stroms für eine andere Anordnung ist in Fig. 6 ebenfalls dargestellt. Die Anordnung kann so ausgelegt sein, dass der Eingangsstrom $I_{E2}$ steiler ansteigt als der Strom $I_{E1}$ Der Scheitelwert des Stroms $I_{E2}$ tritt bei einer kleineren Spannung als der Scheitelwert des Stroms $I_{E1}$ auf. Der abfallende Teil $I_A$ des Stroms schneidet die Kurve $I_{Konst}$ in Punkt $U_{max}$, wodurch sichergestellt wird, dass die maximal zulässige Verlustleistung nicht überschritten wird. Durch den steileren Anstieg des Stroms $I_{E2}$ gegenüber dem Strom $I_{E1}$ tritt bei kleineren Werten der Eingangsspannung die für eine bestimmte Störungsempfindlichkeit notwendige Verlustleistung auf, so dass bei Anordnungen mit fallender Kennlinie die Störempfindlichkeit verbessert wird. Eine besonders hohe Störempfindlichkeit im gesamten Bereich verbessert wird. Eine besonders hohe Störempfindlichkeit im gesamten Bereich für alle Spannungswerte ergibt sich, wenn die Kennlinie möglichst nahe unter der max. Verlustleistung bleibt Vielfach reicht aber eine Anordnung mit Strombegrenzung auf einen konstanten Wert aus. Die Anordnungen können im Rahmen des grossen Spannungsbereichs ohne Widerstandsanpassung oder andere Anpassungsmanahmen eingesetzt werden

Die Fig. 7 zeigt eine Anordnung mit fallender Kennlinie des Stroms in Abhängigkeit von der Eingangsspannung. Die Anordnung enthält einen ersten Feldeffekttransistor (FET) 34 in Reihe mit einem Optokoppler 35, einem Widerstand 36 und einem weiteren Widerstand 37. Der FET 34 wird durch einen hochohmigen Kreis angesteuert, der die Reihenschaltung eines Widerstandes 38 und zweier Zener-Dioden 39, 40 enthält. Die Gate-Elektrode des FET 34 wird an die gemeinsame Verbindungsstelle der Zener-Dioden 39, 40 gelegt, die über einen Widerstand 41 an den Bezugs- bzw. Gegenpol der Spannungsquelle gelegt ist. Die Reihenschaltung der Elemente 38, 39, 40 ist hochohmiger als der Zweig mit dem FET 34. Ein zweiter FET 42 wird über die Drain-Elektrode des FET 34 gesteuert und liegt in Reihe mit zwei Widerständen 43, 44. Der Zweig mit dem FET 42 und den Widerständen 43, 44 ist gemeinsam mit dem den FET 34 enthaltenden Zweig über einen Widerstand 45 an den Bezugspol angeschlossen. Der Zweig mit dem FET 42 ist niederohmiger als der Zweig mit dem FET 34. Ein Mitkopplungswiderstand 46 liegt zwischen der Drain-Elektrode des FET 42 und der Verbindung zwischen dem Widerstand 38 und der Zener-Diode 39. Eine Mitkopplung wird auch durch den Widerstand 45 erreicht Eine Gegenkopplung aus der Reihenschaltung einer Diode 47, eines Widerstands 48 und einer Zener-Diode 49 ist zwischen der Source-Elektrode des FET 42 und der Zener-Diode 39 angeordnet

Der Strom setzt ein, wenn die Schwellenspannung des FET 42 erreicht ist, und steigt danach in Abhängigkeit der Widerstände 44, 45 linear mit der Spannung an. Wenn die Summe aus den Zener-Spannungen (39, 40) und der Schwellenspannung des FET 34 sowie der am Widerstand 45 anstehenden Spannung von der Eingangsspannung überschritten wird, ist der FET 34 leitend. Dabei wird die Mitkopplung wirksam, so dass der Strom über den FET 34 mit einem Mindestwert einsetzt, der den Optokoppler 35 voll durchsteuert. Bei weitersteigender Spannung steigt der Strom über den FET 34 höher an, wodurch der Strom über den FET 42 abnimmt. Da der Strom über den FET 42 stärker abnimmt als der Strom über den FET 34 zunimmt, nimmt der Gesamtstrom der Anordnung mit weiter ansteigender Spannung ab. Um zu verhindern, da bei weiter fallendem Strom die Verlustleistung der Anordnung und damit die Störfestigkeit einen Minimalwert unterschreitet, ist die Gegenkopplung vorgesehen, die die Abnahme reduziert. Wenn die Eingangsspannung so hoch ist, dass der Spannungsabfall am Widerstand 41 die Zener-Spannung der Zener-Diode 40 erreicht, wird das Steuerpotential am FET 34 konstant gehalten, so dass der Gesamtstrom konstant bleibt

Beim Zurückgehen der Eingangsspannung wird der Punkt des Sperrens des FET 34 bei niedrigerer Spannung erreicht als beim Leitendwerden. Deshalb hat die Schaltung eine Hysterese.

## Ansprüche

1. Anordnung zum Umsetzen eines veränderlichen Eingangssignals in ein binäres Informationssignal mit einem Detektor (5), der bei bestimmten Werten des Eingangssignals sein binäres Ausgangssignal von einem in den anderen binären Zustand ändert,
**dadurch gekennzeichnet,**
dass eine Strombegrenzungsschaltung (4) den Eingangsstrom der Anordnung, der zugleich Laststrom für die Signalquelle des Eingangssignals ist, mit steigender Spannung nur bis zu einem Maximalwert ansteigen lässt und bei weiter wachsenden Eingangssignalen auf einen in etwa konstanten oder wieder sinkenden Wert begrenzt.

2. Anordnung nach Anspruch 1,
**dadurch gekennzeichnet,**
dass das durch die Strombegrenzungsschaltung (4) belastete Eingangssignal im Detektor (5) ein binäres Ausgangssignal der einen oder anderen Wertigkeit erzeugt, je nachdem, ob der Signalpegel eine vorgegebene Schwelle über- oder unterschreitet.

3 Anordnung nach Anspruch 1 oder 2,
**dadurch gekennzeichnet,**
dass die Strombegrenzungsschaltung (4) Elemente enthält, die jeweils den Strom auf einen höheren und einen niedrigeren Wert begrenzen, und dass die Elemente, die den Strom auf einen niedrigeren Wert begrenzen, innerhalb einer vorgebbaren Zeit nach dem Einschalten der Spannung für die Strombegrenzung unwirksam wird.

4. Anordnung nach einem oder mehreren der vorhergehenden Ansprüche,
**dadurch gekennzeichnet,**
daß die Strombegrenzungsschaltung (4) ein Verstärkerelement enthält, das in Reihe mit mindestens einem Widerstand (21; 22) an von der Spannung beaufschlagte Leitungen angeschlossen ist und dessen Steuereingang an die gemeinsame Verbindungsstelle der an die Leitungen (13, 15) angeschlossenen Reihenschaltung eines Widerstands und eines Spannungsbegrenzungselements gelegt ist.

5. Anordnung nach einem oder mehreren der vorhergehenden Ansprüche,
**dadurch gekennzeichnet,**
daß das Verstärkerelement ein Transistor ist, dessen Steuerelektrode an der gemeinsamen Verbindungsstelle angeschlossen ist.

6. Anordnung nach Anspruch 4 oder 5,
**dadurch gekennzeichnet,**
daß das Spannungsbegrenzungselement eine Zener-Diode (19) ist.

7. Anordnung nach Anspruch 1, 2 oder 3,
**dadurch gekennzeichnet,**
daß die Strombegrenzungsschaltung eine Konstantstromdiode ist.

8. Anordnung nach Anspruch 5,
**dadurch gekennzeichnet,**
daß der Transistor ein Feldeffekttransistor (20) ist.

9. Anordnung nach Anspruch 1 oder einem der folgenden Ansprüche,
**dadurch gekennzeichnet,**
daß die Leitungen (13, 15) über einen Gleichrichter (17, 26) an die Strombegrenzungsschaltung (4) angeschlossen sind.

10. Anordnung nach Anspruch 9,
**dadurch gekennzeichnet,**
daß der Gleichrichter ein Brückengleichrichter (26) ist.

11. Anordnung nach einem oder mehreren der vorhergehenden Ansprüche,
**dadurch gekennzeichnet,**
daß ein Kondensator (24) parallel zum einen Widerstand (22) angeordnet ist.

12. Anordnung nach einem der Ansprüche 4 bis 6 oder 8,
**dadurch gekennzeichnet,**
daß im Source-Kreis des Feldeffekttransistors (20) bzw. im Emitter-Kreis eines bipolaren Transistors zwei Widerstände (21, 22) in Reihe geschaltet sind, daß der eine und/oder der andere Widerstand (21, 22) an einen Schwellwertdiskriminator (23, 25) angeschlossen ist und daß der Kondensator (24) zu einem Widerstand (22) parallel gelegt ist.

13. Anordnung nach einem der Ansprüche 1 bis 5 oder 8,
**dadurch gekennzeichnet,**
daß im Source-Kreis des Feldeffekttransistors (20) bzw. im Emitter-Kreis eines bipolaren Transistors zwei Widerstände (21, 22) in Reihe geschaltet sind, daß der Kondensator (24) zu einem Widerstand (22) parallel geschaltet ist und daß eine Lumineszenzdiode (27) eines Optokopplers (28) in Reihe mit einem Widerstand (21) oder dem anderen Widerstand (22) angeordnet ist.

14. Anordnung nach einem der Ansprüche 1 bis 5 oder 8,
**dadurch gekennzeichnet,**
daß eine Lumineszenzdiode eines Optokopplers (32) im Drainkreis des Feldeffekttransistors bzw. im Kolektorkreis des ipolaren Transistors angeordnet ist.

15. Anordnung nach einem oder mehreren der Ansprüche 9 bis 13,
**dadurch gekennzeichnet,**
daß in dem vom Eingangssignal gespeisten Stromkreis ein spannungsbegrenzendes Element, insbesondere eine Zener-Diode (33) in Reihe mit der Strombegrenzungsschaltung (4) angeordnet ist.

# FIG.1

Strombegrenzungsschaltung 4

Detektor 6 5

2

3

1

# FIG.2

2

11

7

8

1 →

9

10

5

6

3

# FIG.3

2

17

15

14

15

12

13

18

20

19

24

21

22

23

25

16

3

1

# FIG.4

# FIG.5

Fig. 6

Fig. 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 156 560 (MOTOROLA INC.)<br>* Seite 9, Zeile 25 - Seite 10, Zeile 10; Seite 11, Zeile 26 - Seite 12, Zeile 10; Figuren 1,6 * | 1,2 | G 01 R 19/165 |
| A | --- | 5,8,11 | |
| A | US-A-3 959 667 (D.R. BOYD)<br>* Spalte 2, Zeile 27 - Spalte 2, Zeile 56; Figur 2 *<br>--- | 3 | |
| A | FR-A-2 449 898 (J. MENARD)<br>* Seite 2, Zeile 31 - Seite 3, Zeile 19; Figuren 1,2 *<br>--- | 3,12 | |
| A | EP-A-0 143 111 (TÜZELESTECHNIKAI KUTATO-ES FEJLESZTÖ VALLALAT)<br>* Seite 5, Zeile 33 - Seite 6, Zeile 5 *<br>--- | 1,4 | |
| A | EP-A-0 063 356 (MITSUBISHI DENKI K.K.)<br>* Seite 4, Zeile 7 - Seite 7, Zeile 4; Figur 5 *<br>--- | 4-6,9, 10 | RECHERCHIERTE SACHGEBIETE (Int. Cl.4) |
| A | US-A-3 932 797 (YORK)<br>* Figur 1A; Spalte 19, Zeilen 29-47 *<br>--- | 12 | G 01 R 19/00 |
| A | US-A-4 247 849 (MORRIS et al.)<br>* Spalte 3, Zeilen 22-31; Figur 2 *<br>--- | 13 | |
| A | US-A-3 969 697 (IWASA et al.)<br>* Figuren 5,6 *<br>----- | 14 | |

Der vorliegende Recherchenbericht wurde für alle Patentansprüche erstellt

| Recherchenort | Abschlußdatum der Recherche | Prüfer |
|---|---|---|
| DEN HAAG | 07-04-1989 | TRELEVEN C. |